# EUROPEAN PATENT APPLICATION

(11) **EP 2 722 871 A1**
(43) Date of publication of application: **23.04.2014**
(21) Application number: 13188844.8
(22) Date of filing: 16.10.2013
(51) Int. Cl.: H01L 21/02

(54) **A method of depositing an amorphous silicon film**

(30) Priority: 18.10.2012 GB 201218697; 18.10.2012 US 201261715411 P
(71) Applicant: SPTS Technologies Limited, Newport Gwent NP18 2TA (GB)
(72) Inventor: Patel, Jash, Bristol, BS19 4HR (GB); Liu, Yufei, Swansea, SA1 8NH (GB)
(74) Representative: Lambert, Ian Robert

(57) **Abstract**

According to the invention there is provided a method of depositing in a chamber an amorphous silicon layer on a surface of a semiconducting or insulating substrate wherein the surface is pretreated with a NH₃ plasma prior to deposition of the amorphous silicon layer.

## Description

This is invention relates to methods for the deposition of amorphous silicon films and in particular such films with a thickness of 3µm or above thicknesses.

It has been found that when seeking to deposit the thicker amorphous silicon films, such as those with a thickness of 3µm or above, there can be significant problems with adhesion of the film to the substrate surface. Currently this is limiting the use of amorphous silicon film, especially in the MEMS industry.

Amorphous silicon is the non-crystalline allotropic form of silicon. It can be deposited in thin films onto a variety of substrates, offering some unique capabilities for a variety of electronics applications. Amorphous silicon is used in Microelectromechanical systems (MEMS) and Nanoelectromechanical systems (NEMS), Solar cells, Microcrystalline and micromorphous silicon, Large-scale production, and even available for roll-to-roll processing technique on various substrates. Specific MEMS applications for amorphous silicon films are:
1. thin film devices, including photodiodes or thin film transistors for colour or infrared sensing or piezoresistors for pressure sensors.;
2. masking layers for glass etching in micro-fluidic applications, or even as thin electrodes in a dielectrophoretic chip, because of its good resistance in highly concentrated HF solutions;
3. sacrificial layers in the micro-fabrication of capacitive ultrasonic transducers because of its simple removal in an alkaline solution (TMAH or KOH);
4. definion of a nano-gap in piezoelectric resonators for mechanical RF magnetic field modulation by dry-release removal of a-Si:H films by XeF₂ etching. ;
5. providing an interlayer for anodic bonding in order to improve bonding quality or in the fabrication of nano-fluidic channels.

The Applicants have developed a method for improving adhesion of a-Si:H thin films and, with additional features in particular embodiments, to lowering stress and improving uniformity.

The invention includes a method of depositing, in a chamber, an amorphous silicon layer on a surface of a substrate when the surface is pretreated with a NH₃ plasma prior to deposition of the amorphous silicon layer.

In embodiments of the invention the NH₃ plasma may have at least one of the following process conditions:
(a) an RF power supplied in the range of 150-250W;
(b) the NH₃ flow rate is between 80 and 110 sccm;
(c) the chamber pressure is between 800-1000m Torr;
(d) the NH₃ plasma is run for about 5 minutes.

The substrate may be made of silicon or a silicon containing material. The substrate may be silicon or glass (Si02). The substrate may be coated with an intermediate layer of silicon dioxide or silicon nitride. However, the invention is not limited to such embodiments.

It is preferred that the substrate is heated to a constant temperature across its width by a flow of inert gas so as to improve the uniformity of the subsequent process steps. Conveniently the inert gas is N₂.

The amorphous silicon film may be deposited using SiH₄ as a process gas and this may be carried in a carrier gas, for example argon.

Typically, the chamber includes a platen. The platen temperature during the deposition of the amorphous silicon film may be between 200 °C and 350 °C, for example 200°C. Preferably the chamber walls are at ∼ 75°C and, where a showerhead is used for delivering the process gas, the showerhead, if used, may have a temperature in the region of 200°C.

When deposited in the above manner, the stress of the amorphous film may be low, for example less than or equal to 50MPa.

Although the invention has been defined above, it is to be understood that it includes any invention combination of the features set out above or in the following description, drawings or claims.

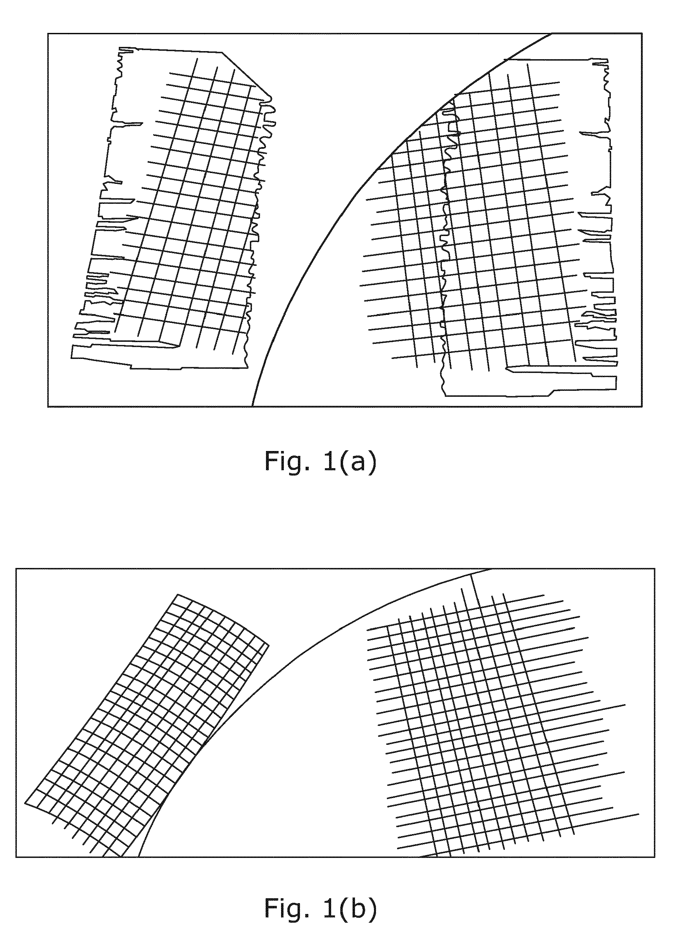

The invention may be performed in various ways and a specific example will now be described in connection with the accompanying Figures in which: Figures 1 a and 1 b contrast the adhesion test results for a 3.2µm silicon film deposition when deposited (a) using normal deposition techniques and (b) when using an embodiment of the present invention;

Figure 2 is a schematic structure of a substrate with Si-OH bonds on the top surface; and

Figure 3 shows a schematic of a representative PECVD system.

In order to improve adhesion , lower stress, and improve uniformity during the amorphous silicon deposition step a novel NH₃ plasma substrate treatment step has been developed.

As an example, a low stress amorphous silicon film that does not show any signs of delamination has been successfully achieved with the following process steps. The process parameters are shown in Table 1.

**Table 1 Example process parameters for 3.26µm thick amorphous silicon film deposition* with good adhesive property.**

| Step | Process | Time (min) | RF Power | Gas flow rate (sccm) | Pressure (mTorr) |
|---|---|---|---|---|---|
| 1 | N₂ heat up | 2 | No power | N₂: 2000 | 2000 |
| 2 | NH₃ plasma | 5 | 200 W (13.56 MHz) | NH₃: 95 | 900 |
| 3 | A-Si deposition | 30 | 120 W (13.56 MHz) | SiH₄: 120 | 700 |
| | | | | Ar: 500 | |
| *deposition was carried out at 200°C of shower head and platen temperatures, and 75°C of chamber sidewall temperature. | | | | | |

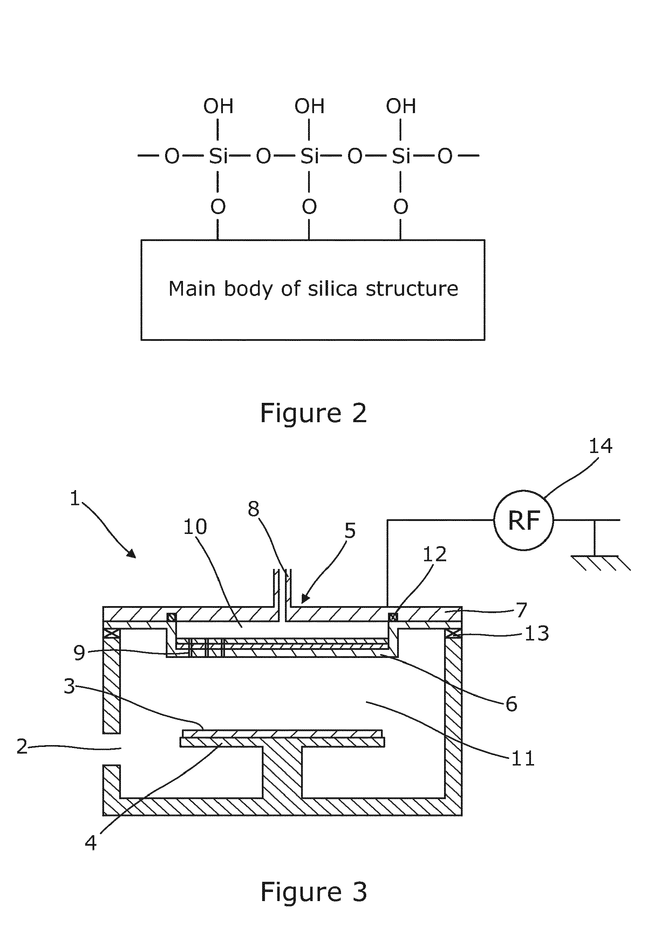

Wafers are loaded into the process module which can comprise a vacuum processing chamber as shown in Figure 3. In Figure 3, the vacuum processing chamber, depicted generally at 1, comprises a pumping orifice 2 which connects the chamber to a pump (not shown). The substrate 3 is placed on a platen 4 and may be clamped in place by known means such as an electrostatic clamp. The chamber 1 further comprises a showerhead assembly 5 which consists of a faceplate 6 and a backing plate 7 with a gas inlet 8. Holes 9 are formed through the faceplate. A volume 10 between the faceplate and the backing plate acts as a gas reservoir to allow conduction between the gas inlet 8 and the process volume 11. Suitable seals are provided, e.g. at 12 and at 13. An RF power supply 14 supplies RF power to the showerhead assembly 5 to create and sustain a plasma in a manner which is well understood to the skilled reader. Further details concerning the configuration and operation of the PECVD system can be found in US publication 2004/0123800, entire contents of which are herein incorporated by reference.

Wafers are loaded into the process module at reduced pressure (<0. 1 Torr) and brought to process temperature with the aid of N₂ (>2Torr and ∼ 2000 sccm). At temperature a NH₃ plasma treatment step was carried out using a RF (14) driven showerhead (5, 6) as can be seen in Figure 3. This step modifies the surface of the substrate 3 on platen 4.

The NH₃ plasma substrate treatment step is a key process step for increasing the adhesion property between the deposited amorphous silicon film and the substrate. For example, an NH₃ plasma substrate treatment step of 200W high frequency power (13.56MHz), 900mTorr pressure and 95sccm NH₃ gas flow for 5 min.The film stress could be further tuned by running at low temperature deposition process (as low as 200°C) for extra low stress film deposition (≤50 MPa);

Experimentally it was found that an amorphous silicon film deposited at low temperature, coupled with optimised process parameters of RF frequencies, power, pressure and gas flows, could produce a very low stress (≤50 MPa) amorphous silicon film. For example, at 200°C for showerhead and platen temperatures, 75°C for chamber side wall temperature, deposition with 120W high frequency power (13.56MHz), 700mTorr process chamber pressure, 120 sccm for SiH₄ and 500 sccm for Ar gas flows would offer the extra low tensile stress amorphous silicon film deposition (+48.1MPa) with a deposition rate about 109 nm/min.

In Figure 1 a) no NH3 pre-treatment and b) NH3 plasma treatment, we can see the benefits of this procedure with regard to a-Si:H film (3.25µm thick) adhesion to a silicon wafer. The adhesion test used the ANSI/SDI A250.10-1998 (R2004) procedure. All of the a-Si:H deposition was removed by the tape in 1a) while no a-Si:H was removed in 1b). The cross hatching on the film is part of the procedure to ensure a reproducible result. The stress of these films could be controlled from tensile to compressive component by varying the process parameters of temperature, power, gas flow rates and pressure. For example, increasing the platen temperature from 200°C to 300°C, the stress could be tuned from <50MPa tensile to>200MPa compressive. By lowering the RF power, the tensile stress could also be increased.

It will be seen that it is the NH₃ plasma substrate treatment step which has significantly increased the amorphous silicon film adhesion property.

The traditional methods for enhancing the deposited film adhesion property may include increasing the amorphous silicon film deposition temperature and introducing an intermediate layer, such as silicon nitride and silicon dioxide, but both of the methods have shortcomings. Elevated temperature >350°C will not be acceptable in many applications due to stress and thermal budget considerations while the introduction of additional layers results in cost, complication and potentially unwanted films to be subsequently removed.

The following experiments were carried out for comparison of the film adhesion enhancement.

**Table 2 : Amorphous silicon film deposited at higher temperature without NH₃ plasma step*. Film thickness ∼3.36µm.**

| Step | Process | Time (min) | RF Power | Gas flow rate (sccm) | Pressure (mTorr) | Adhesion property |
|---|---|---|---|---|---|---|
| 1 | N₂ heat up | 2 | No power | N₂: 2000 | 2000 | 10% fail |
| 2 | A-Si deposition | 30 | 120 W (13.56 MHz) | SiH₄: 120 | 700 | |
| | | | | Ar: 500 | | |
| *deposition was carried out at 250°C of shower head temperature, 350°C of platen temperature and 75°C of chamber sidewall temperature. | | | | | | |

The results in Table 2 show that a higher platen temperature (350 °C) may enhance the adhesion property, but it also introduced a high compressive stress for the deposited amorphous silicon film. With the above example, the higher temperature deposition resulted in 10% fail of the standard adhesion test with film in -332.9 MPa high compressive stress.

**Table 3: Amorphous silicon film deposited with silicon nitride (SiN) interlayer without NH₃ plasma step**

| Step | Process | Time (min) | RF Power | Gas flow rate (sccm) | Pressure (mTorr) | Adhesion property |
|---|---|---|---|---|---|---|
| 1 | SiN deposition (∼100nm) | 5 | 30W (13.56 MHz) | SiH₄: 40 | 900 | 60% fail |
| | | | | NH₃: 55 | | |
| | | | | N₂: 1960 | | |
| Wafer has been unloaded and reloaded (vacuum break) | | | | | | |
| 2 | N₂ heat up | 2 | No power | N₂: 2000 | 2000 | |
| 3 | A-Si deposition | 30 | 120 W (13.56 MHz) | SiH₄: 120 | 700 | |
| | | | | Ar: 500 | | |

**Table 4: Amorphous silicon film deposited with SiO₂ interlayer without NH₃ plasma step**

| Step | Process | Time (min) | RF Power | Gas flow rate (sccm) | Pressure (mTorr) | Adhesion property |
|---|---|---|---|---|---|---|
| 1 | SiO₂ thermal growth | 125.8 nm in thickness | | | | 100% fail |
| Wafer has been loaded for A-Si deposition from room environment after the SiO₂ thermal growth (vacuum break) | | | | | | |
| 2 | N₂ heat up | 2 | No power | N₂: 2000 | 2000 | |
| 3 | A-Si deposition | 30 | 120 W (13.56 MHz) | SiH₄: 120 | 700 | |

The results in Table 3 & 4 (both for films ∼3.3µm) have show the poor adhesion of the deposited amorphous silicon film, with either SiN or SiO₂ interlayer, and without NH₃ plasma step.

**Table 5. Summary of delamination tests on various surfaces on Si wafers.**

| Surface | NH3 plasma treatment (Y/N) | a-Si-H disposition temperature | % Film delamination (100% bad, 0% good) |
|---|---|---|---|
| SiO2 (thermal oxide) | N | 200 | 100 |
| SiN (PECVD) | N | 200 | 60 |
| Si (wafer) | N | 350 | 10 |
| Si(wafer) | N | 200 | 100 |
| Si(wafer) | Y | 200 | 0 |

Table 5 summarizes the key findings from Tables 1-4. Namely that for Si, SiO₂ and SiN surfaces that have experienced a vacuum break all a-Si:H films show signs of delamination with the exception of the NH₃ plasma treated substrate. Raising the process temperature to 350°C substantially reduces the amount of delamination; however even this aggressive process is not as productive as the low stress 200°C a-Si:H deposition onto Si that has been treated with NH₃ plasma step..

A possible mechanism to understand the improvement in adhesion of the a-Si:H films is described as follows. A silicon surface that has been exposed to atmosphere will have native oxide layer. At the wafer surface the silicon atoms are joined via oxygen atoms in a giant covalent structure. However, at the surface of the silicon dioxide, the silicon-oxygen bonds are hydrolysed in air with time and form -OH groups. Therefore, at the surface, there are Si-OH bonds instead of Si-O-Si bonds as shown in Fig. 2. The surface is polarised, because of the -OH groups, and can form hydrogen bonds with suitable compounds around it as well as Van der Waals dispersion forces and dipole-dipole attractions. Apart from the dangling bonds of the deposited amorphous silicon, these Si-OH bonds on the substrates surface affect the adhesion property significantly between the deposited amorphous silicon film and the substrates.

Thus, with the use of the NH₃ plasma substrate treatment step to remove the Si-OH bonds on the top surface of the substrate, the adhesion of the deposited amorphous silicon film is improved significantly.

## Claims

1. A method of depositing in a chamber an amorphous silicon layer on a surface of a semiconducting or insulating substrate wherein the surface is pretreated with a NH₃ plasma prior to deposition of the amorphous silicon layer.

2. A method as claimed in claim 1 wherein the NH₃ plasma has at least one of the following process conditions:
(a) an RF power supplied in the range of 150-250W;
(b) the chamber pressure is between 500-4000m Torr;
(c) the NH₃ plasma is run for about 1-5 minutes; and
(d) the amorphous silicon layer is subsequently carried out without a vacuum break.

3. A method as claimed in claim 1 or claim 2 wherein the substrate is made of silicon.

4. A method as claimed in claim 1 or claim 2 wherein the surface of the substrate is made of silicon dioxide or silicon nitride.

5. A method as claimed in any one of the preceding claims wherein the substrate is heated to a constant temperature across its width by a flow of inert gas prior to the application of the NH₃ plasma.

6. A method as claimed in claim 5 wherein the inert gas is N₂.

7. A method as claimed in any one of the preceding claims wherein the amorphous silicon film is deposited using SiH₄ as the process gas.

8. A method as claimed in claim 7 wherein the chamber includes a platen, and the platen temperature is between 200-350°C, for example 200°C.

9. A method as claimed in claim 8 wherein the stress of the film is ≤50MPa.
